# EUROPEAN PATENT APPLICATION

(11) **EP 4 576 977 A1**
(43) Date of publication of application: **25.06.2025**
(21) Application number: 23218690.8
(22) Date of filing: 20.12.2023
(51) Int. Cl.: H10B 43/27, G11C 23/00

(54) **MEMORY CELL FOR A 3D NAND FLASH MEMORY**

(71) Applicant: Imec VZW, 3001 Leuven (BE)
(72) Inventor: VERRECK, Devin, 3212 Pellenberg (BE); RACHIDI, Sana, 3000 LEUVEN (BE)
(74) Representative: Lind Edlund Kenamets Intellectual Property AB

(57) **Abstract**

According to an aspect, there is provided a memory cell (100) for a 3D NAND flash memory (1), the memory cell (100) comprising: a gate layer (14); a channel layer (32); a memory stack (40) arranged between the gate layer (14) and the channel layer (32) and comprising a charge trap layer (27) and a tunneling oxide layer (30), with the charge trap layer (27) facing the gate layer (14); and an insulating piezoelectric gate layer (50) arranged on the gate layer (14), wherein the piezoelectric gate layer (50) and the memory stack (40) are separated by an air gap (52). According to another aspect, there is provided vertical memory array (1) for a 3D NAND flash memory. According to yet another aspect, there is provided a method for forming a vertical memory array (1) for a 3D NAND flash memory.

## Description

### TECHNICAL FIELD

The present invention generally relates to memory cell for a 3D NAND flash memory, a memory array comprising a vertical stack of memory cells, and a method for forming a memory array for a 3D NAND flash memory.

### BACKGROUND

NAND flash memories plays a crucial role in electronic storage, leveraging NAND gate-based architectures to achieve non-volatile data retention. NAND technology is characterized by high-density, cost-efficient data storage, with rapid access times. Its intrinsic ability to retain data integrity in the absence of power renders it indispensable for various applications, including USB drives, SSDs, and memory cards. Today, vertically stacked NAND flash memories represent the dominant NAND flash memory technology. In such memories, flash cells are vertically stacked along so-called memory strings.

NAND memories store information in the form of charge carriers in a charge trap layer or a floating gate that is part of a flash cell transistor. The concentration of stored charge carriers corresponds to stored information bits and can be read by its resulting threshold voltage shift of the flash cell. Further, quantum tunneling is utilized to change the charge carrier concentration in the flash cell, thereby writing or erasing information. The performance of a NAND flash memory cell may be characterized by its programming onset and programming efficiency. The programing onset is related to the voltage needed to provide a significant threshold voltage change in the memory cell, whereas the programming efficiency is related to the rate of change in the threshold voltage with increasing applied voltage. Hence both programming onset and programming efficiency determine the programming voltage that is required to reach the target threshold voltage shift that corresponds with the programmed state of the cell. In this regard, low programming voltages are generally desirable.

Further, a high programming efficiency is beneficial for the disturb behavior of the memory cell, as it increases the difference between the threshold voltage shift that occurs during read mode and programming mode. It also increases the window between different programming levels in multi-level cell operation. However, to obtain an early programming onset and high programming efficiency, the blocking oxide used in the memory cell should satisfy competing requirements. Firstly, to reduce the onset, a high permittivity of the blocking oxide is desired, as this increases the electric field over the tunneling oxide during the program operation and thereby enhances the injection of carriers into the charge storage layer. Secondly, to achieve a high programming efficiency, a low permittivity of the blocking oxide is desired, as this increases the impact of the stored charge on the cell threshold voltage during the read operation. Thirdly, to prevent a reduction of programming efficiency due to excessive carrier flow through to the gate of the memory cell, a sufficient conduction band offset is desired between the blocking oxide and the charge storage layer. Despite several attempts to mitigate the above competing requirements, there is room still for improvement when it comes to providing efficient NAND flash memories.

### SUMMARY

In light of the above, it is an object of the present invention to provide an improved memory cell for a 3D NAND flash memory, which addresses at least some of the competing requirements of the blocking oxide, as well as to provide a vertical memory array for a 3D NAND flash memory including a number of memory cells and a method for forming a vertical memory array.

Another object is to provide a memory cell for a 3D NAND flash memory which has a low programming onset and a high programming efficiency.

Another object is to provide a memory cell for a 3D NAND flash memory which has an increased programming efficiency as compared to prior art memory cells.

To achieve at least one of the above objects and also other objects that will be evident from the following description, a memory cell for a 3D NAND flash memory having the features defined in claim 1 is provided. A vertical memory array for a 3D NAND flash memory comprising a number of memory cells is provided according to claim 5. A method for forming a vertical memory array for a 3D NAND flash memory is provided according to claim 11. Embodiments of the present invention will be evident from the dependent claims.

Hence, according to an aspect of the present invention, there is provided a memory cell for a 3D NAND flash memory, the memory cell comprising: a gate layer; a channel layer; a memory stack arranged between the gate layer and the channel layer and comprising a charge trap layer and a tunneling oxide layer, with the charge trap layer facing the gate layer; and an insulating piezoelectric gate layer arranged on the gate layer, wherein the piezoelectric gate layer and the memory stack are separated by an air gap.

Thus, the memory cell according to the present aspect is based on the idea that programming onset and programming efficiency may be improved by replacing a traditional blocking oxide of a memory cell for a 3D NAND flash memory with an insulating piezoelectric gate layer (which in the following may be abbreviated "piezoelectric gate layer") in combination with an air gap. By arranging the piezoelectric gate layer on the gate layer and separating the piezoelectric gate layer and the memory stack by the air gap, the thickness of the piezoelectric gate layer will increase when the piezoelectric gate layer is subjected to a voltage. As a result, the air gap will become smaller when the thickness of the piezoelectric gate layer increases and the piezoelectric gate layer expands into the air gap. This means that the thickness of the piezoelectric gate layer will increase more during a programming operation than during a read operation of the memory cell, since programing the memory cell is performed using a higher voltage as compared to reading out the memory cell. In practice, about 15-20 volts may be used during a programming operation whereas about 5-10 volts may be used during a read operation. The above behavior of the piezoelectric gate layer and the air gap will consequently result in an increased combined permittivity during a programming operation as compared to a read operation of the memory cell.

By tailoring the material and the thickness of the piezoelectric gate layer a negligible change, or (substantially) no change, of the thickness of the piezoelectric gate layer may be realized during a read operation whereas an outspoken increase of the thickness of the piezoelectric gate layer may be realized during a programming operation. To this end, the combined permittivity of the piezoelectric gate layer and the air gap may by substantially unaffected during a read operation but may at the same time increase during a programming operation. The above behavior of the piezoelectric gate layer and the air gap will consequently result in a different equivalent oxide thickness (EOT) during a read operation as compared to a programing operation of the memory cell. More specifically, the EOT of the piezoelectric gate layer and the air gap will decrease as the thickness of the piezoelectric gate layer increases and the piezoelectric gate layer expands into the air gap. This means that the EOT of the piezoelectric gate layer and the air gap will be lower during a programming operation as compared to a read operation. Thus, both the programming onset and programming efficiency of the memory cell may be improved. Further, the retention properties of the memory cell may be improved since the presence of the air gap may reduce loss of charge carriers into the gate layer as compared to when a high-k blocking oxide is used. More specifically, the presence of the air gap (in combination with the piezoelectric gate layer) may result in a higher band offset as compared to a state of the art high-k blocking oxide.

By "the charge trap layer facing the gate layer" is here meant that the charge trap layer is closer to the gate layer than the tunneling oxide layer is.

By "air gap" is here meant a space or void separating the piezoelectric gate layer and the memory stack. The space may contain air and/or other ambient gases which may be present in the process environments in which the memory cell is fabricated. The space may typically be void of any solid material. However, the space may comprise traces of solid material used while forming the air gap. To this end, the traces of solid material may form a sparse porous structure or network. Such traces may have no significant effect or no effect on the expansion of the piezoelectric gate layer into the air gap.

In some embodiments, a dimension of the air gap may be in a range from 0.5 nm to 5 nm. By the air gap having a dimension in the range from 0.5 nm to 5 nm, the air gap may be sufficiently thin such that when a voltage is applied to the gate layer of the memory cell during a programming operation, charge carriers may tunnel through the tunneling oxide from the channel layer and into the charge trap layer. Further, by the air gap having a dimension in the range from 0.5 nm to 5 nm, the piezoelectric gate layer may expand into the airgap without contacting the memory stack (assuming a typical range of programming voltages). Thus, the piezoelectric gate layer may expand into the airgap without fully closing the air gap, which reduces the risk of stiction or adhesion between the piezoelectric gate layer and the memory stack. The dimension of the air gap here refers to the dimension in a non-biased state, i.e. in absence of any electrical field across the piezoelectric gate layer.

In some embodiments, a dimension of the air gap may be in a range from 0.5 nm to 2 nm.

In some embodiments, the piezoelectric gate layer may have a thickness in a range from 2 nm to 10 nm, and a thickness expansion in a range from 0.2 % to 1.2 % per volt applied to the piezoelectric gate layer, which is advantageous in that the piezoelectric gate layer may expand during a programming operation of the memory cell such that the combined permittivity of the piezoelectric gate layer and the airgap is increased during a programming operation.

By "a thickness expansion per volt applied to the piezoelectric gate layer" is here meant to which extent the thickness of the piezoelectric gate layer increases per volt applied across the piezoelectric gate layer, i.e. along a thickness of the piezoelectric gate layer (as seen from the gate layer towards the memory stack).

The thickness of the piezoelectric gate layer may increase by at least 5% responsive to a voltage in a range of 10-20 volts.

The thickness of the piezoelectric gate layer may advantageously increase by about 10% responsive to a voltage in a range of 10-20 volts.

In some embodiments, the piezoelectric gate layer may comprise one or more of HfO₂, Si doped HfO₂, ZnO, BN, BaTiO₃, AIN and GaN.

According to another aspect of the invention, there is provided a vertical memory array for a 3D NAND flash memory comprising a number of memory cells according to the previous aspect, wherein the memory cells are stacked on top of each other along a vertical direction to form a stack of memory cells. In general, features of this aspect provide similar advantages as discussed above in relation to the previous aspect. Consequently, said advantages will not be repeated in order to avoid undue repetition.

In some embodiments, the air gap of each memory cell may be formed by a respective portion of a common air gap extending continuously through the stack of memory cells along the vertical direction. Hence, each memory cell may be located at a respective portion of an air gap being common to all memory cells of the vertical memory array.

In some embodiments, the piezoelectric gate layer of each memory cell may be a discrete (insulating) piezoelectric gate layer arranged between a respective pair of inter-gate spacer layers. Thus, "discrete" refers to a respective discrete (i.e., separate and disconnected) portion of the piezoelectric gate layer. More specifically, each memory cell may have an associated discrete piezoelectric gate layer which is separated from corresponding discrete piezoelectric gate layers of adjacent memory cells. In this way, a voltage applied to a discrete piezoelectric gate layer of a memory cell may influence adjacent memory cells less as compared to when a common piezoelectric gate layer extends through the stack of memory cells along the vertical direction.

In some embodiments, the vertical memory array may comprise inter-gate spacer layers arranged alternatingly with the gate layers. Such inter-gate spacer layers may be formed of a dielectric material, typically an oxide.

In some embodiments, the air gap of each memory cell may be formed by a respective portion of a common air gap extending continuously through the stack of memory cells along the vertical direction when the piezoelectric gate layer of each memory cell is a discrete piezoelectric gate layer arranged between a respective pair of inter-gate spacer layers.

In some embodiments, the air gap of each memory cell may be a discrete air gap arranged between a respective pair of inter-gate spacer layers. Hence, each memory cell may have an associated discrete air gap which is separated from corresponding discrete air gaps of adjacent memory cells.

In some embodiments, the vertical memory array may further comprise an insulating liner layer extending continuously through the stack of memory cells along the vertical direction, at a position between the air gap and the charge trap layer of each memory cell. Such insulating liner layer may assist in forming the air gap during fabrication of the vertical memory array.

According to another aspect of the invention, there is provided a method for forming a vertical memory array for a 3D NAND flash memory, the method comprising: forming a layer stack over a substrate, the layer stack comprising an alternating sequence of gate layers and inter-gate spacer layers; forming, along a sidewall surrounding a memory hole in the layer stack, in sequence, a piezoelectric gate layer, a dummy layer and an insulating layer; subjecting the dummy layer to a thermal treatment process adapted to convert the dummy layer into an air gap, wherein the air gap is formed laterally between the piezoelectric gate layer and the insulating liner layer; subsequent to the thermal treatment process, forming, along the insulating liner layer, a charge trap layer, and subsequently, a tunneling oxide layer and a channel layer.

By the present method an improved vertical memory array for a 3D NAND flash memory may be formed. Thus, by the present method, a vertical memory array for a 3D NAND flash memory may be formed in which the air gap is located between the piezoelectric gate layer and the insulating liner. This means in practice that the air gap will separate the piezoelectric gate layer and the memory stack of the vertical memory array being formed.

In general, features of this aspect provide similar advantages as discussed above in relation to the previous aspect. Consequently, said advantages will not be repeated in order to avoid undue repetition.

In some embodiments, the method may further comprise, prior to forming the piezoelectric gate layer: forming recessed areas in the sidewall of the layer stack by laterally etching back the gate layers from the memory hole; wherein the piezoelectric layer is formed selectively in the recessed areas such that a discrete piezoelectric gate layer is formed in each recessed area.

In some embodiments, the dummy layer may be formed selectively on the discrete piezoelectric gate layer in each recessed area. By forming the dummy layer selectively on the discrete piezoelectric gate layer in each recessed area, a discrete air gap may be formed in each recessed area.

In some embodiments, the dummy layer may be formed as a continuous layer along the sidewall of the memory hole. By forming the dummy layer as a continuous layer along the sidewall of the memory hole a common air gap which extends continuously through the stack of memory cells along the vertical direction may be formed.

In some embodiments, the dummy layer may be formed of a polymer-comprising material. There exist many polymers that may be efficiently and reliably removed using a thermal treatment process, e.g. by evaporation, leaving substantially no organic residues in the air gap being formed (although non-polymer traces may remain).

In some embodiments, the insulating liner layer may be deposited at a temperature below a temperature causing conversion of the dummy layer. Accidental conversion of the dummy layer before the air gap is "sealed off" by the liner layer may thus be avoided.

In some embodiments, the insulating liner layer may be formed of a low thermal oxide (LTO). A low thermal oxide (e.g. LTO SiO₂) may be reliably deposited without triggering conversion of the dummy layer.

In some embodiments, a thickness of the insulating liner layer may be in a range of 1-4 nm, or 1-2 nm. An insulating liner layer in this thickness range allows decomposed components (e.g. vapor-phase components) of the dummy layer, formed upon conversion into air gaps, to exit the (i.e. diffuse) through the liner layer.

### BRIEF DESCRIPTION OF THE DRAWINGS

This and other aspects of the present invention will now be described in more detail, with reference to the appended drawings showing embodiments of the present invention.
Fig. 1 schematically shows a memory cell according to an embodiment.
Fig. 2a-b schematically shows a schematic cross-sectional view, and a top-down view, respectively, of a starting structure for forming a memory array according to an embodiment.
Fig. 3 shows the structure after formation of an insulating piezoelectric gate layer, a dummy layer and an insulating liner.
Fig. 4 shows the structure after converting the dummy layer into an air gap.
Fig. 5 shows the structure after formation of a charge trap layer and a tunneling oxide layer.
Fig. 6 shows the structure after formation of a channel layer.
Fig. 7 shows the structure of Fig. 2a after formation of recessed areas in the gate layers.
Fig. 8 shows the structure after formation of a piezoelectric gate layer, and a dummy layer.
Fig. 9 shows the structure after formation of an insulating liner.
Fig. 10 shows the structure after converting the dummy layer into an air gap.
Fig. 11 shows the structure after formation of a charge trap layer and a tunneling oxide layer.
Fig. 12 shows the structure after formation of a channel layer.

### DETAILED DESCRIPTION

Embodiments of memory cells and memory arrays for a 3D NAND flash memory, such as a 3D-Gate-All-Around-NAND (3D GAA NAND), as well as methods for forming such memory array will now be described with reference to the drawings. The drawings are only schematic and the relative dimensions of some structures and layers may be exaggerated and not drawn on scale. Rather the dimensions may be adapted for illustrational clarity and to facilitate understanding of the following description. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to a supporting substrate of the memory structure. The term "vertical" refers to a direction parallel to a normal direction of the substrate, i.e. transverse to the substrate.

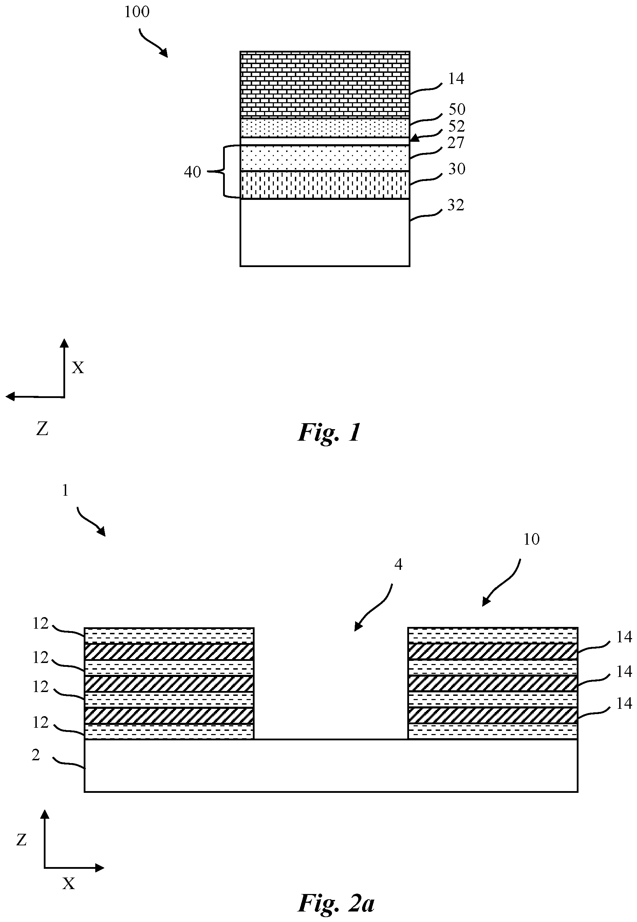

Fig. 1 schematically shows a memory cell 100 for a 3D NAND flash memory according to an embodiment. The depicted memory cell 100 includes a gate layer 14 and a channel layer 32. A memory stack 40 is arranged between the gate layer 14 and the channel layer 32. The memory stack 40 comprises a charge trap layer 27 and a tunneling oxide layer 30. The charge trap layer 27 is facing the gate layer 14. That is, the charge trap layer 27 is closer to the gate layer 14 than the tunneling oxide layer 30 is. An insulating piezoelectric gate layer 50 is arranged on the gate layer 14. The piezoelectric gate layer 50 will hereinafter be referred to as the PZ layer 50. The PZ layer 50 and the memory stack 40 are separated by an air gap 52.

The gate layer 14 may be a nitride-comprising layer, such as a SiN layer, thus forming a sacrificial gate layer 14 intended to be replaced by a replacement metal gate (RMG) stack in subsequent process steps. The gate layer 14 may also be a functional gate layer, e.g. a metal layer or a highly doped polysilicon-comprising layer.

The channel layer 32 may be formed by any suitable channel material conventionally used in the industry for channel layers, typically a semiconductor material such as Si, SiGe or Ge.

The charge trap layer 27 of the memory stack 40 may comprise or be SiN (i.e. Si₃N₄), or some other oxide material suitable to be used as a charge trap material. The charge trap layer 27 may have a thickness in a range of 4 nm to 8 nm.

The tunneling oxide 30 of the memory stack 40 may be formed of any material conventionally used in the industry for tunneling oxide layers, one non-limiting example being SiON. The tunneling oxide 30 may have a thickness in a range of 3 nm to 8 nm.

The PZ layer 50 may be formed of a suitable insulating piezoelectric material, such as a piezoelectric oxide or nitride. The PZ layer 50 may have a thickness of 2 nm to 10 nm. That is, a thickness as seen along the X-axis of Fig. 1 may be 2 nm to 10 nm. Non-limiting examples of suitable materials for the PZ layer 50 are HfO₂, Si doped HfO₂, ZnO, BN, BaTiO₃ and GaN. Such suitable materials for the PZ layer 50 all expand when subjected to a voltage. That is, a thickness of the PZ layer 50 formed of said materials will increase when the PZ layer 50 is subjected to a voltage. Thus, when the PZ layer 50 is subjected to a voltage, the thickness of the PZ layer 50 will increase such that the PZ layer 50 expands into the air gap 52 while a thickness of the air gap 52 is decreased correspondingly. By forming the PZ layer 50 of said suitable materials, the PZ layer 50 may have a thickness expansion in a range from 0.2 % to 1.2 % per volt applied to the PZ layer 50.

The air gap 52 may have a dimension from 0.5 nm to 5 nm. That is, a thickness as seen along the X-axis of Fig. 1 may be 0.5 nm to 5 nm.

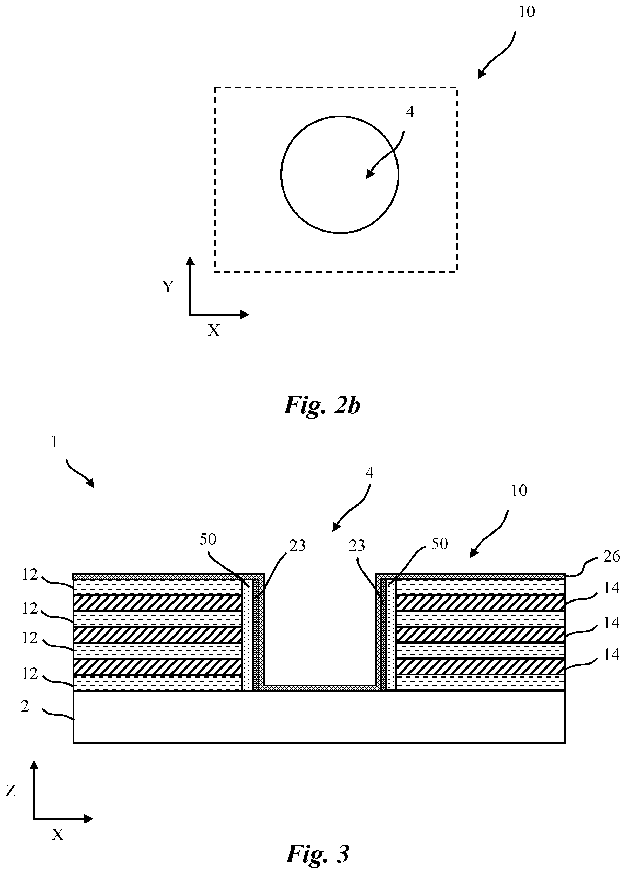

In the following, a method for forming a vertical memory array 1 for a 3D NAND flash memory comprising a number of memory cells 100 of the above type will be described with reference to Figs. 2-6.

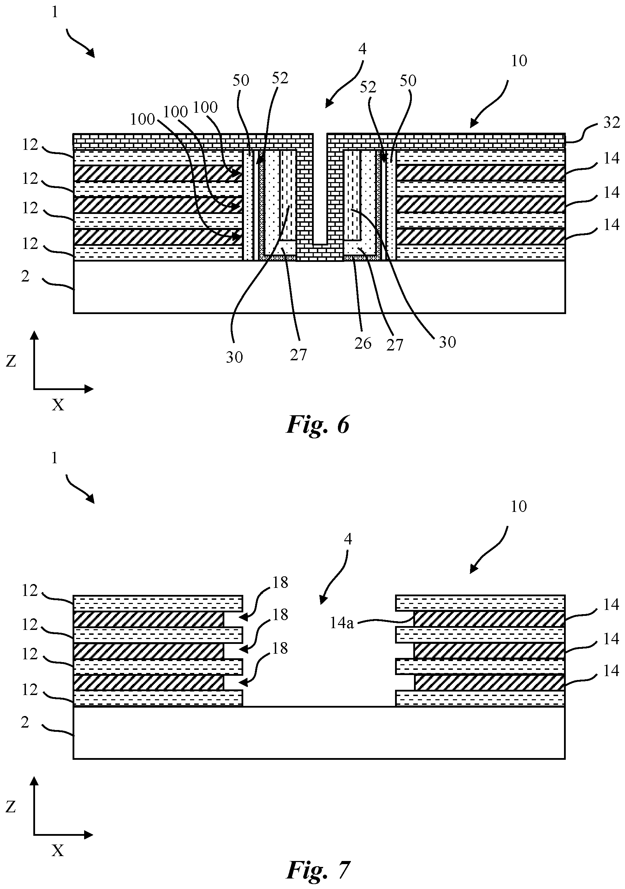

Fig. 2a-b schematically shows a cross-sectional view, and a top-down view, respectively, of a structure 1 at an initial stage of the method. The structure 1 comprises a layer stack 10 representing a precursor or starting structure for the vertical memory array 1 which is to be formed, and as shown in Fig. 7, to be subjected to the processing steps of the method disclosed in the following.

The layer stack 10 is formed over a substrate 2 and comprises an alternating sequence of gate layers 14 and inter-gate spacer layers 12.

The substrate 2 may be a conventional substrate, suitable for semiconductor processing and for supporting a memory structure for a 3D NAND flash memory. The substrate 2 may for instance be a Si substrate, a Ge substrate or a SiGe substrate. Other examples include a silicon-on-insulator (SOI) substrate, a GeOI substrate or a SiGeOI substrate.

The gate layers 14 may be nitride-comprising layers, such as SiN layers, thus forming sacrificial gate layers 14 intended to be replaced by an RMG stack in subsequent process steps. The gate layers 14 may also be functional gate layers, e.g. highly doped polysilicon-comprising layers.

The inter-gate spacer layers 12 may be oxide-comprising layers, such as SiO₂ layers or another suitable inter-layer dielectric (e.g. of low-k). The inter-gate spacer layers 12 are arranged in the layer stack 10 to provide vertical separation between the memory cells / word lines of the memory device which is to be formed.

The layer stack 10 may be formed by interchangeably depositing layers of gate material (e.g. nitride) and inter-gate spacer material (e.g. oxide) using deposition processes which per se are known in the art, such as chemical vapor deposition (CVD), physical vapor deposition (PVD) or atomic layer deposition (ALD).

The inter-gate spacer layer 12 and the gate layers 14 may be formed in numbers in accordance with the intended number of stacked memory cells of the memory device. It is to be noted that the number of layers 12, 14 of the illustrated layer stack 10 merely is a non-limiting example and that the method disclosed herein is compatible with stacks of memory cells of essentially any number currently used, or contemplated, in the industry, such as 64, 128, 256 or greater.

The inter-gate spacer layers 12 and the gate layers 14 may be formed with a respective layer thickness in a range of 5-25 nm, as an example. A z-pitch of the layer stack 10 (i.e. the combined thickness of one inter-gate spacer layer and one gate layer 14) may be in a range from about 45 nm to 15 nm or less.

After depositing the layers 12 and 14 of the layer stack 10, a memory hole 4 may be patterned in the layer stack 14, e.g. by a lithography and etching process. While Fig. 2a-b shows a portion of the layer stack 10 surrounding a single memory hole 4, it is noted that a corresponding memory hole 4 may be patterned at each location where a respective vertical string of memory cells is desired. The memory hole 4 may as shown be formed to extend through each one of the inter-gate spacer layers 12 and gate layers 14 of the layer stack 10. The memory hole 4 may as further shown in the top-down view of Fig. 1b be formed with a circular cross-sectional shape, such that the memory hole 4 may be formed with a substantially circular cylindrical shape. However, the memory hole 4 may also be formed with other cross-sectional shapes, such as an oval or polygonal shape.

While not shown in Fig. 2a, the layer stack 10 may as per se is known in the art further comprise, underneath the layers 12, 14, a sub-stack of a select layer and a source layer for forming a select plate and a source plate, respectively, of the memory device. The select and source layers may hence form a bottom sub-stack of the layer stack 10. The select and source layers may be formed by conventional techniques and materials, e.g. doped semiconductor layers (e.g. polysilicon), and be separated by layers of interlayer dielectric.

In Fig. 3, a PZ layer 50, a dummy layer 23 and an insulating liner layer 26 have been formed in sequence along a sidewall surrounding the memory hole 4 of the layer stack 10. The PZ layer 50 may be formed of any of the examples of insulating piezoelectric materials mentioned in connection with Fig. 1.

The PZ layer 50 may have a thickness of 2 nm to 10 nm. That is, a thickness as seen along the X-axis of Fig. 1 may be 2 nm to 10 nm. Non-limiting examples of suitable materials for the PZ layer 50 are HfO₂, Si doped HfO₂, ZnO, BN, BaTiO₃, AlN and GaN. The PZ layer 50 may be formed by depositing the material of the PZ layer by ALD or CVD.

The depicted dummy layer 23 is conformally deposited (e.g. using ALD) along the sidewall of the memory hole 4 subsequent to forming the PZ layer 50. Hence, the dummy layer 23 is conformally deposited on the PZ layer 50 as illustrated in Fig. 3. Following deposition, the dummy layer 23 may be subjected to an anisotropic etch oriented top-down (negative Z-direction) to remove portions of the dummy layer 23 deposited on horizontal surfaces of the structure 1, such as the bottom of the memory hole 4 and the top surface of the layer stack 10. A conventional dry etch process, such as reactive ion etch (RIE), ion beam etch (IBE) or other a plasma etch or may be used. Thus, the dummy layer 23 is formed as a continuous layer along the sidewall of the memory hole 4. The dummy layer 23 defines a temporary place holder for the air gap 52 which later is to be formed. The dummy layer 23 is formed of a dummy material selected so as to be convertible into an air gap 52 by a thermal treatment process. Example materials for the dummy layer 23 include polymer-comprising materials, such as a tetracyclododecene (TD)-based sacrificial polymer, polycycloolefin polymers (such as polynorbornene polymers), or some other conventional thermally degradable polymer which may be deposited on the PZ layer 50.

The depicted insulating liner layer 26 is conformally deposited (e.g. using ALD) to cover the sidewall of the memory hole 4, and thus to cover the dummy layer 23. As illustrated in Fig. 3, the insulating liner layer 26 is also deposited to cover the uppermost inter-gate spacer layer 12. That is the insulating liner layer 26 is covering a top surface of the layer stack 10 as well as the sidewall of the memory hole 4. After depositing the insulating liner layer 26, the dummy layer 23 is hence sealed off from the memory hole 4. More specifically, the dummy layer 23 is sandwiched between the insulating liner layer 26 and the PZ layer 50.

The liner layer 26 is deposited with a thickness so as to allow the decomposed components (e.g. vapor-phase components) of the dummy layer 23, formed when the dummy layer 23 is converted into an air gap 52 during the subsequent thermal treatment process, to exit (i.e. diffuse) through the insulating liner layer 26. The insulating liner layer 26 may be formed with a thickness in a range of 1-4 nm, or 1-2 nm. The insulating liner layer 26 may be formed of porous SiO₂. The insulating liner layer 26 may be a low thermal oxide (LTO), such as LTO SiO₂. By depositing the insulating liner layer 26 at a thermal budget with a sufficient margin towards the conversion temperature of the dummy material of the dummy layer 23, premature conversion of the dummy layer 23 may be avoided. For example, for any of the above examples of dummy materials, a deposition temperature of the liner layer 26 at 300 °C or lower may typically provide a sufficient margin.

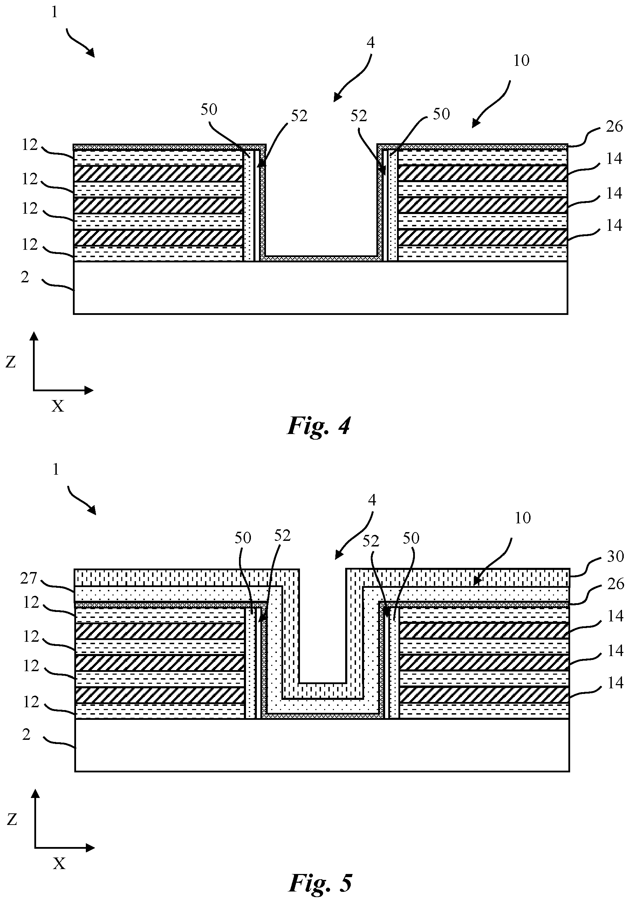

Fig. 4 shows the structure 1 after converting the dummy layer 23 into an air gap 52. Hence, the air gap 52 is formed laterally between the PZ layer 50 and the insulating liner layer 26. The conversion is achieved by subjecting the dummy layer 23 to a thermal treatment process adapted to convert the dummy material (e.g. polymer) of the dummy layer 23 into an air gap 52. The treatment process may be performed by performing a thermal anneal (e.g. in a reactor chamber or furnace). The thermal energy needed to achieve a sufficient conversion ratio is, as would be understood by the skilled person, dependent on the specific dummy material of the dummy layer 23. For example, for any of the above examples of dummy materials, heating the structure 1 or an ambient of the structure to about 500 °C will typically be sufficient to completely convert the dummy layer 23 without any appreciable formation of residues in the resulting air gap 52.

It is further contemplated that the dummy material may include components or additives which during the thermal treatment process are converted to, or remain to, form low k sparse matrix or porous air gap structures (organic or non-organic), e.g. of silicate compounds such as (low k) organo silicate (SiOC) or fluorinated silicate (SiOF), remaining in the air gap 52. The air gap 52 is hence not limited to a void spanning the full volume previously occupied by the dummy material, but may also include a low k sparse structures surrounded by air, or including pores with air. However, even in the case of a remaining spares structure, at least a majority portion of the volume spanned by the air gap 52 will typically be filled with air.

Fig. 5 shows the structure 1 after formation of a charge trap layer 27 along the insulating liner layer 26, and subsequently a tunnelling oxide layer 30. Thus, a charge trap layer 27, and subsequently a tunnelling oxide layer 30 have been formed in the memory hole 4 along the sidewall thereof. The charge trap layer 27 is thus formed along the liner layer 26 and the tunnelling oxide layer 30 formed along the charge trap layer 27.

The charge trap layer 27 may be conformally deposited on the insulating liner layer 26 (e.g. using ALD). The charge trap layer 27 may include any suitable charge trap material conventionally used in the industry for charge trap layers 27, one non-limiting example being SiN. The charge trap layer 27 may be formed with a thickness in a range of 4-8 nm.

The tunneling oxide layer 30 may be formed of any material conventionally used in the industry for tunneling oxide layers, one non-limiting example being SiON.

Fig. 6 shows the structure 1 after formation of a channel layer 32 along the sidewall of the memory hole 4. As illustrated in Fig. 6, the insulating liner layer 26, the charge trap layer 27 and the tunnelling oxide layer 30 may be etched back above the layer stack 10 as well as at the bottom of the memory hole 4 prior to forming the channel layer 32. Thus, the insulating liner layer 26, the charge trap layer 27 and the tunnelling oxide layer 30 may be removed from horizontal surfaces of the structure 1 (e.g. the bottom of the memory hole 4, the top surface of the layer stack 10) using a top-down anisotropic etch process prior to forming the channel layer 32. Hence, the insulating liner layer 26, the charge trap layer 27 and the tunnelling oxide layer 30 may be removed using an anisotropic etching process such as RIE, IBE or other a plasma etch. In the illustrated example, the etch back has been performed after each of the insulating liner layer 26, the charge trap layer 27 and the tunnelling oxide layer 30 have been deposited. However, it is also possible to first perform the etch back of the insulating liner layer 26 and the charge trap layer 27, thereafter deposit the tunnelling oxide layer 30, and subsequently perform the etch back of the tunnelling oxide layer 30.

The channel layer 32 may be formed by any suitable channel material conventionally used in the industry for channel layers, typically a semiconductor material such as Si, SiGe or Ge.

The depicted channel layer 32 of Fig. 6 is a macaroni type channel layer 32, where the channel layer 32 extends along along the sidewall of the memory hole 4. In case of a macaroni type channel layer 32, a remaining portion of the memory hole 4 may typically be filled with a filler oxide subsequent to forming the channel layer 32. Although not depicted, the channel layer may be formed as a so-called full channel layer where the channel layer fills the entire memory hole 4.

While not shown in Fig. 6, the channel layer 32 may present an extension outside of the illustrated portion of the structure 1, to facilitate connection to peripheral semiconductor devices and circuitry, such as select transistors, as per se is known to the skilled person.

Thus, in Fig. 6 a vertical memory array 1 for a 3D NAND flash memory comprising a number of memory cells 100 has been formed. In the vertical memory array 1, the memory cells 100 are stacked on top of each other along a vertical direction to form a stack of memory cells. As illustrated in Fig. 6. The air gap 52 of each memory cell is formed by a respective portion of the common air gap 52 extending continuously through the stack of memory cells along the vertical direction.

If the gate layers 14 are sacrificial gate layers, the method may proceed with replacing the sacrificial gate layers 14 by a replacement metal gate (RMG) stack. The sacrificial gate layers 14 may be removed by etching back the sacrificial gate layers 14 from a second hole (not shown) in the layer stack 10 (e.g. denoting the memory hole 4 as a front side hole or opening the second hole may be referred to as a backside hole or opening). The thusly formed lateral cavities formed at the levels of the sacrificial gate layers 14 may subsequently be filled with a replacement metal gate stack replacing the sacrificial gate layers 14. Replacement metal gate stack deposition may as per se is known in the art comprise depositing one or more conductive layers, e.g. a metal such as one or more of TiN and W. The deposition of the conductive layer(s) may be preceded by deposition of a (conformal) high-k gate dielectric.

In the following, an alternative method for forming a vertical memory array 1 for a 3D NAND flash memory comprising a number of memory cells 100 will be described with reference to Figs. 7-12.

Fig. 7 shows the structure 1 of Figs. 2a and 2b after the structure 1 has been subjected to further processing steps. In Fig. 7, recessed areas 18 have been formed in the sidewall surrounding the memory hole 4 by laterally etching back the gate layers 14 relative the inter-gate spacer layers 12 from the memory hole 4.

The gate layers 14 are laterally etched back (along the X-axis) selectively to the inter-gate spacer layers 12 such that the recessed areas 18 are formed between the inter-gate spacer layers 12. That is, each recessed area / recess of the recessed areas 18 is formed between a pair of inter-gate spacer layers 12. Due to the circumferential extension of the sidewall about the memory hole 4, the recessed areas 18 may extend circumferentially about the memory hole 4. In the example of a circular memory hole 4, the first recessed areas 18 may thus be annular.

The gate layers 14 may be etched back using an etching process adapted to etch the gate layers 14 selectively to the inter-gate spacer layers 12. That is, the etching process may be adapted to etch (i.e. remove) the material (e.g. the nitride material) of the gate layers 14 selectively to the material (e.g. the oxide material) of the inter-gate spacer layers 12, e.g. such that the gate layers 14 may be laterally etched back without causing any substantial etchback of the inter-gate spacer layers 12. The etching process may be applied to the sidewall of the layer stack 10 via the memory hole 4. Any suitably selective etching process, wet or dry, providing a sufficient lateral etching component with respect to the gate layers 14 (such as an isotropic etching process) may be used.

The recessed areas 18 may be formed with a depth (along the X-axis) matching an intended lateral combined thickness of the PZ layer 50 and the air gap 52 to be formed. The depth (i.e. the amount of lateral etch back) of the recessed areas 18 may for example be in a range of 2.5-15 nm. The depth of the recessed areas 18 may be controlled by timing the lateral etch back.

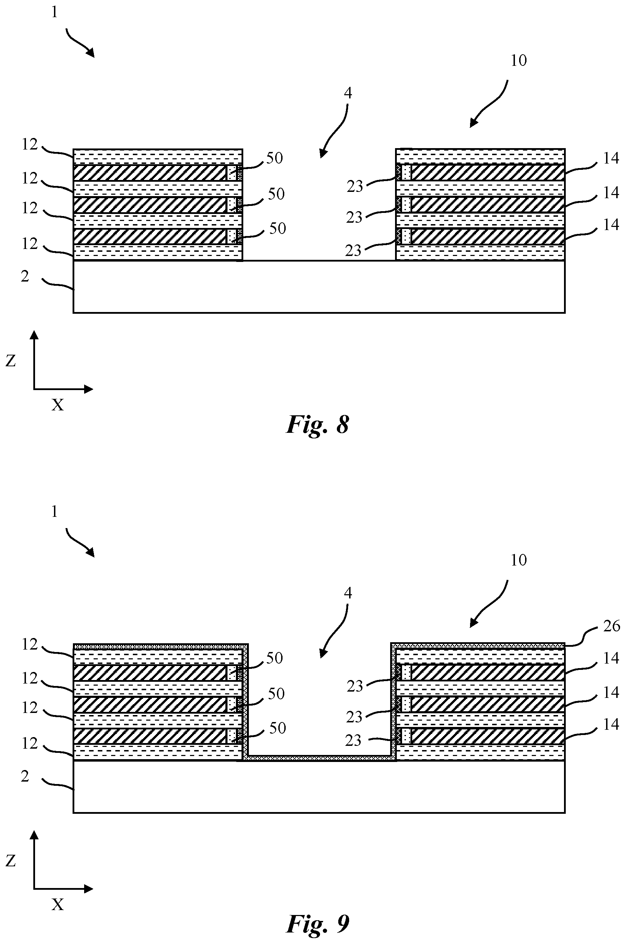

In Fig. 8, a PZ layer 50 and a dummy layer 23 have been formed in sequence in the recessed areas 18 surrounding the memory hole 4 of the layer stack 10.

The PZ layer 50 may be of the type described above in conjunction with Fig. 1. However, as depicted in Fig. 8, the PZ layer may be formed selectively in the recessed areas 18 such that the PZ layer 50 comprises a number of discrete portions separated along the vertical direction of the memory hole 4.

The dummy layer 23 may be of the type described above in conjunction with Fig. 1. The dummy layer 23, may as illustrated in Fig. 8 be formed selectively in the recessed areas 18 on the PZ layer 50 such that the dummy layer 23 comprises a number of discrete portions separated along the vertical direction of the memory hole 4.

To this end, the PZ layer 50 may be formed using an area-selective deposition technique. That is the PZ layer 50 may be formed in the recessed areas 18 while not being formed or substantially not being formed on the inter-gate spacer layers 12. The PZ layer 50 may be deposited using any deposition process (e.g. an ALD or CVD process) allowing area-selective deposition of the PZ layer 50 such that the PZ layer 50 is deposited on growth-promoting or seeding surface portions in the recessed areas 18 but not on the growth-inhibiting areas of the inter-gate spacer layers 12. The growth-promoting surface portions may in particular be defined by the surface portions (i.e. the end surfaces 14a indicated in Fig. 7) of the etched back gate layers 14 exposed in the recessed areas 18.

The dummy layer 23 may be deposited using any deposition process (e.g. an ALD or CVD process) allowing area-selective deposition of dummy material such that the dummy material 23 is deposited on growth-promoting or seeding surface portions in the recessed areas 18 but not on the growth-inhibiting areas of the inter-gate spacer layers 12. The growth-promoting surface portions may in particular be defined by the already deposited PZ layer 50.

To facilitate a selective deposition of the PZ layer 50, the layer stack 10 may be subjected to a treatment step prior to depositing the PZ layer 50, adapted to functionalize the surface portions / end surfaces 14a of the etched back gate layers 14 in the recessed areas 18 and thereafter depositing the PZ layer 50 on the functionalized surface portions in the recessed areas 18. For instance, the functionalization may comprise depositing a deposition-promoting layer (not shown) on the surface portions 14a of the etched back gate layers 14 in the recessed areas 18.

Additionally or alternatively, the layer stack 10 may be subjected to a treatment process adapted to passivate exposed surface portions of the inter-gate spacer layers 12 with respect to the selective deposition of the PZ layer 50 and the dummy layer 23. For instance, as per se is known in the art, some deposition processes favor deposition on hydrogen terminated surfaces (e.g. the deposition process deposits material preferentially on hydrogen terminated surfaces). A treatment process may hence be adapted to increase an occurrence of hydrogen terminated bonds on the gate layers 14 (thus promoting deposition thereon) and/or reduce an occurrence of hydrogen terminated bonds on the inter-gate spacer layers 12 (thus inhibiting deposition thereon). This is however merely one non-limiting example and other techniques are known to the skilled person.

As an alternative to area selective deposition of the PZ layer 50, it is also possible to deposit the PZ layer 50 conformally, and thereafter performing an etch back process to remove portions of the PZ layer 50 deposited outside the recesses 18. The etch back may comprise an anisotropic etch oriented top-down (negative Z-direction), such that the portions of the PZ layer 50 in the recesses 18 are shadowed or masked from above and thus may be preserved. By depositing the PZ layer 50 with a thickness such that the recesses 18 are pinched off (implying that a local thickness of the PZ layer 50 is greater in the recesses 18 than outside the recesses 18, it is also possible to etch back the PZ layer 50 using an isotropic etch back. By stopping the etch back when end surfaces of the inter-gate spacer layers 12 are exposed portions of the PZ layer 50 may thus remain in the recesses 18 to define the a final PZ layer 50 formed selectively in the recesses 18. Analogous approaches may be applied to form the dummy layer 23 selectively in the recesses 18 on the PZ layer 50.

In Fig. 9, an insulating liner layer 26 has been formed. The insulating liner layer 26 may be of the type described above in conjunction with Fig. 3.

The depicted insulating liner layer 26 of Fig. 9 is conformally deposited (e.g. using ALD) to cover the sidewall of the memory hole 4, and thus cover the dummy layer 23 and the end surfaces of the inter-gate spacer layers 12. As illustrated in Fig. 9, the insulating liner layer 26 is also deposited to cover the uppermost inter-gate spacer layer 12. That is the insulating liner layer 26 is covering a top surface of the layer stack 10 as well as the sidewall of the memory hole 4. After depositing the insulating liner layer 26, each discrete portion of the dummy layer 23 is hence sealed off from the memory hole 4. More specifically, each discrete portion of the dummy layer 23 is sandwiched between the insulating liner layer 26 and the PZ layer 50 while at the same time being restricted in the vertical direction (i.e. along the Z-axis) of the memory hole 4 by a pair of inter-gate spacer layers 12 as illustrated in Fig 9. Thus, the PZ layer 50 of each memory cell is a discrete PZ layer 50 arranged between (i.e. vertically) a respective pair of inter-gate spacer layers 12.

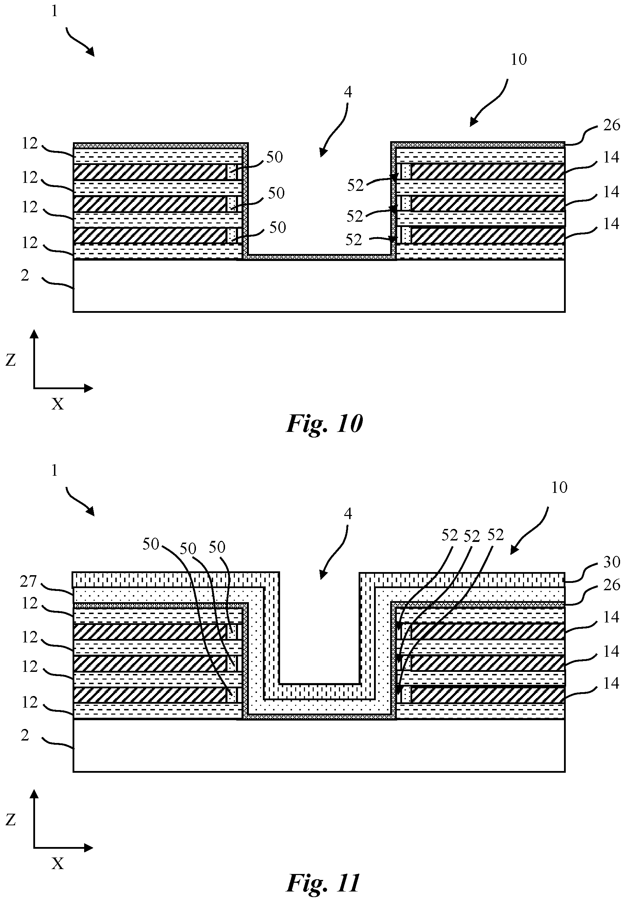

In Fig. 10, the dummy layer 23 has been converted into the air gap 52. Hence, the air gap 52 of Fig. 10 is for each memory cell a discrete air gap 52 arranged between a respective pair of inter-gate spacer layers 12. The dummy layer 23 may be converted into the air gap 52 as have been described above in conjunction with Fig. 4.

Fig. 11 shows the structure 1 after formation of a charge trap layer 27 along the insulating liner layer 26, and subsequently a tunnelling oxide layer 30. The charge trap layer 27 and the tunnelling oxide layer 30 may be formed as described above in conjunction with Fig. 5.

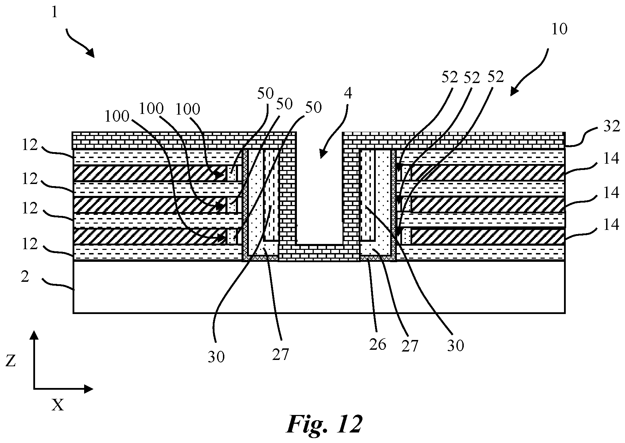

Fig. 12 shows the structure 1 after formation of a channel layer 32 along the sidewall of the memory hole 4. As illustrated in Fig. 12, like in Fig. 6, the the insulating liner layer 26, the charge trap layer 27 and the tunnelling oxide layer 30 may be etched back above the layer stack 10 as well as at the bottom of the memory hole 4 prior to forming the channel layer 32. The channel layer 32 may be formed as described above in conjunction with Fig. 6. Thus, in Fig. 12 a vertical memory array 1 for a 3D NAND flash memory comprising a number of memory cells 100 has been formed. In the vertical memory array 1, the memory cells 100 are stacked on top of each other along the vertical direction to form a stack of memory cells. As illustrated in Fig. 12 the air gap 52 of each memory cell 100 is a discrete air gap 52 arranged between a respective pair of inter-gate spacer layers 12.

If the gate layers 14 are sacrificial gate layers, the method may proceed with replacing the sacrificial gate layers 14 by a replacement metal gate stack as have been described above.

The person skilled in the art realizes that the present invention by no means is limited to the embodiments described above. On the contrary, many modifications and variations are possible within the scope of the appended claims. According to an example, the PZ layer 50 of each memory cell 100 may be formed a discrete PZ layer 50 arranged between a respective pair of inter-gate spacer layers 12 while at the same time the air gap 52 of each memory cell 100 may be formed by a respective portion of a common air 52 gap extending continuously through the stack of memory cells along the vertical direction.

To this end, the gate layers 14 may be etched back from the memory hole 4 to form recessed areas 18 in the sidewall of the layer stack 10 as have been described above in conjunction with Fig. 7. The PZ layer 50 may then be formed to fill the recessed areas 18 such that the PZ layer 50 is formed as a discrete PZ layer 50 arranged between a respective pair of inter-gate spacer layers 12. The recessed areas 18 may be thus be formed with a depth (along the X-axis) matching an intended lateral thickness of the PZ layer 50 to be formed. The dummy layer 23, which later is to be converted to the air gap 52, may then be formed as a continuous dummy layer 23 along the sidewall of the memory hole 4. Thus, when the dummy layer 23 later on is converted to the air gap 52, a common air gap 52 extending continuously through the stack of memory cells along the vertical direction may be formed. Hence, the air gap 52 of each memory cell 100 may in this way be formed by a respective portion of the common air 52 gap.

## Claims

1. A memory cell (100) for a 3D NAND flash memory (1), the memory cell (100) comprising:
a gate layer (14);
a channel layer (32);
a memory stack (40) arranged between the gate layer (14) and the channel layer (32) and comprising a charge trap layer (27) and a tunneling oxide layer (30), with the charge trap layer (27) facing the gate layer (14); and
an insulating piezoelectric gate layer (50) arranged on the gate layer (14),
wherein the piezoelectric gate layer (50) and the memory stack (40) are separated by an air gap (52).

2. The memory cell (100) according to claim 1, wherein a dimension of the air gap (52) is in a range from 0.5 nm to 5 nm.

3. The memory cell (100) according to claim 2, wherein the piezoelectric gate layer (50) has a thickness in a range from 2 nm to 10 nm, and a thickness expansion in a range from 0.2 % to 1.2 % per volt applied to the piezoelectric gate layer (50).

4. The memory cell (100) according to any one the preceding claims, wherein the piezoelectric gate layer (50) comprises one or more of HfO₂, Si doped HfO₂, ZnO, BN, BaTiO₃, AlN and GaN.

5. A vertical memory array (1) for a 3D NAND flash memory comprising a number of memory cells (100) according to any one of the preceding claims, wherein the memory cells (100) are stacked on top of each other along a vertical direction to form a stack of memory cells.

6. The vertical memory array (1) according to claim 5, wherein the air gap (52) of each memory cell (100) is formed by a respective portion of a common air (52) gap extending continuously through the stack of memory cells along the vertical direction.

7. The vertical memory array (1) according to claim 5, wherein the piezoelectric gate layer (50) of each memory cell (100) is a discrete piezoelectric gate layer (50) arranged between a respective pair of inter-gate spacer layers (12).

8. The vertical memory array (1) according to claim 7, wherein the air gap (52) of each memory cell (100) is formed by a respective portion of a common air gap (52) extending continuously through the stack of memory cells along the vertical direction.

9. The vertical memory array (1) according to claim 7, wherein the air gap (52) of each memory cell (100) is a discrete air gap (52) arranged between a respective pair of inter-gate spacer layers (12).

10. The vertical memory array (1) according to any one of claims 5-9, further comprising an insulating liner layer (26) extending continuously through the stack of memory cells along the vertical direction, at a position between the air gap (52) and the charge trap layer (27) of each memory cell (100).

11. A method for forming a vertical memory array (1) for a 3D NAND flash memory, the method comprising:
forming a layer stack (10) over a substrate (2), the layer stack (10) comprising an alternating sequence of gate layers (14) and inter-gate spacer layers (12);
forming, along a sidewall surrounding a memory hole (4) in the layer stack (10), in sequence, an insulating piezoelectric gate layer (50), a dummy layer (23) and an insulating liner layer (26);
subjecting the dummy layer (23) to a thermal treatment process adapted to convert the dummy (23) layer into an air gap (52), wherein the air gap (52) is formed laterally between the piezoelectric gate layer (52) and the insulating liner layer (26);
subsequent to the thermal treatment process, forming, along the insulating liner layer (26), a charge trap layer (27), and subsequently, a tunneling oxide layer (30) and a channel layer (32).

12. The method according to claim 11, further comprising, prior to forming the piezoelectric gate layer (50):
forming recessed areas (18) in the sidewall of the layer stack (10) by laterally etching back the gate layers (14) from the memory hole (4);
wherein the piezoelectric layer (50) is formed selectively in the recessed areas (18) such that a discrete piezoelectric gate layer (50) is formed in each recessed area (18).

13. The method according to claim 12, wherein the dummy layer (23) is formed selectively on the discrete piezoelectric gate layer (50) in each recessed area (18).

14. The method according to claim 12, wherein the dummy layer (23) is formed as a continuous layer along the sidewall of the memory hole (4).

15. The method according to any one of claims 11-14, wherein the dummy layer (23) is formed of a polymer-comprising material.
